# EUROPÄISCHE PATENTANMELDUNG

(11) **EP 1 296 431 A2**
(43) Veröffentlichungstag der Anmeldung: **26.03.2003**
(21) Anmeldenummer: 02020192.7
(22) Anmeldetag: 10.09.2002
(51) Int. Cl.: H02G 5/00

(54) **Sammelschienenblock**

(30) Priorität: 21.09.2001 DE 10146503
(71) Anmelder: ABB PATENT GmbH, 68526 Ladenburg (DE)
(72) Erfinder: Popa, Heinz-Erich, Dr.-Ing., 69245 Bammental (DE); Ritter, Friedhelm, 82041 Oberhaching (DE)
(74) Vertreter: Miller, Toivo

(57) **Zusammenfassung**

Es wird eine in einem Gehäuse untergebrachte elektrische Installationsverteilung beschrieben, die einen in das Gehäuse eingeführten Zugangsleiter und zu einzelnen Verbrauchern führende Abgangsleiter, elektrische Installationsgeräte, wie z. B. Fehlerstromschutzgeräten, Leitungsschutzgeräten und dergleichen, die mit mit dem Zugangsleiter und den Abgangsleitern verbundenen Stromschienen mittels einer Steckverbindung verbindbar sind, und mit eine Tragplatte zur Halterung der Installationsgeräte aufweist, wobei die Stromschienen unterhalb der Tragplatte angeordnet sind und die Tragplatte Öffnungen aufweist, in die an den Installationsgeräten angeordnete Steckelemente zu den Stromschienen hin einführbar sind. Die Stromschienen unterschiedlicher Phase und Zu- und Abgängen sind in gleichen Ebenen gegeneinander und voneinander isoliert angeordnet und in ein Isoliergehäuse eingebettet, vorzugsweise eingegossen.

## Beschreibung

Die Erfindung betrifft eine elektrische Installationsverteilung gemäß dem Oberbegriff des Anspruches 1.

Derartige Installationsverteilungen werden in Gebäuden zur Stromverteilung und Absicherung installiert ; in einem Installationsverteilergehäuse sind Leitungsschutzschalter, Fehlerstromschutzschalter und dgl. untergebracht, mit denen einzelne Verbraucher innerhalb eines Netzes geschützt werden sollen.

Üblicherweise enthalten derartige Gehäuse an ihrem Gehäuseboden Hutprofiltragschienen, auf denen die Schaltgeräte aufgeschnappt werden. Mittels Sammelschienen sind die Schaltgeräte phasenweise miteinander verbunden, wobei bei einphasigen Geräten lediglich eine Sammelschiene und bei mehrphasigen Anordnungen so genannte Sammelschienenblöcke verwendet werden, die ein Sammelschienen - Aufnahmegehäuse mit mehreren Kammern und in die Kammern eingesetzten Flachbandleiter aufweisen, wobei an den Flachbandleitern Anschlußfahnen vorgesehen sind, die in Anschlußklemmen an den Schaltgeräten einsteckbar und darin festklemmbar sind. Wenn mehrere Hutprofiltragschienen übereinander angeordnet sind, dann sind Verbindungsleiteranordnungen vorgesehen, mit denen die einzelnen Sammelschienen verbunden werden.

Aus der DE 196 28 957 A 1 ist eine Installationsverteilung bekannt, die ein Gehäuse aufweist, in dem Flachbandleiter untergebracht sind, an denen Anschlußfahnen angeformt sind, die Kontakttulpen tragen, in die an der Unterseite der Schaltgeräte angeordnete Steckerfahnen einsteckbar sind, wobei am Gehäuse eine Hutprofiltragschiene angebracht ist, auf die die Schaltgeräte aufgeschnappt werden. Beim Aufschnappen gelangen die Steckerfahnen durch im Gehäuse vorgesehene Öffnungen mit den Kontakttulpen in elektrisch leitenden Kontakt. Als Schaltgeräte werden solche verwendet, die eine übliche Schaltgeräteform besitzen ; lediglich auf der Unterseite ist die Stekkerfahne angebracht, anstatt Schraubanschlußklemmen, in die elektrische Leiter durch Öffnungen an den Schmalseiten der Schaltgeräte eingesteckt werden.

Mit dieser Anordnung wird im Vergleich zu hergebrachten Verteilungen schon eine erhebliche Montageerleichterung erreicht, insoweit als wenigstens auf der Zugangsseite des Schaltgerätes das Festklemmen eines elektrischen Leiters oder einer Anschlußfahne einer Sammelschiene mittels eines Werkzeuges nicht mehr erforderlich ist.

In die Verteilung wird eine Zugangsleitung eingeführt, die mit den Sammelschienen verbunden wird ; die den einzelnen Schaltgeräten zugeordneten Abgangsleitungen sind innerhalb des Installationsverteilergehäuses verlegt und aus dem Gehäuse herausgeführt, wobei die Abgangsleitungen an die Zuleitungen zu den Verbrauchern angeschlossen werden. Hier können sich durch Verwechselungen Fehlanschließungen ergeben, beispielsweise so, dass ein mittels eines Fehlerstromschutzschalters abzusichernder Verbraucher irrtümlicherweise an einen Leitungsschutzschalter angeschlossen wird.

Aufgabe der Erfindung ist es, eine Installationsverteilung der eingangs genannten Art zu schaffen, bei der die Montage noch weiter vereinfacht wird und Fehlanschließungen vermieden werden.

Diese Aufgabe wird erfindungsgemäß durch die Merkmale des Anspruches 1 gelöst.

Erfindungsgemäß sind die Stromschienen unterschiedlicher Phasen in gleichen Ebenen phasenweise isoliert voneinander angeordnet, und sind dabei in einen Isolierkörper eingebettet, vorzugsweise eingegossen.

Jeder Stromschiene kann dabei für jede Phase einen quer zur Anreihrichtung der Geräte verlaufenden Verbindungsabschnitt aufweisen, an dem eine der Anzahl der Installationsgeräte - Reihen entsprechende Anzahl von Zungen angebracht sind, die unterhalb der Geräte verlaufen und die die Aufnahmeöffnung für Steckelemente an den Installationsgeräten aufweisen. Die Stromschiene für den Neutralleiter weist ebenfalls einen quer zur Anreihrichtung der Installationsgeräte verlaufenden Verbindungsabschnitt auf, an dem eine der Anzahl der Installationsgeräte - Reihen entsprechende Anzahl von Zungen angebracht sind, die unterhalb der Installationsgeräte verlaufen und die die Aufnahmeöffnungen für die Steckeelemente aufweisen.

Die Stromschienen können dabei übereinander angeordnet sein, wobei die Zungen unterschiedlicher Phasen gegeneinander versetzt sind.

Weitere vorteilhafte Ausgestaltungen der Erfindung, insbesondere Ausgestaltungen der einzelnen Stromschienen, sind den weiteren Unteransprüchen zu entnehmen.

Anhand der Zeichnung, in der einige Ausführungsbeispiele der Erfindung dargestellt sind, sollen die Erfindung sowie weitere vorteilhafte Ausgestaltungen und Verbesserungen und weitere Vorteile näher erläutert und beschrieben werden.

Es zeigen:
Fig. 1 eine Darstellung der einzelnen Phasenstromschienen,
Fig. 2 eine Schnittansicht durch ein Stromschienengehäuse,
Fig. 3 eine Schnittansicht durch ein Stromschienengehäuse mit unterschiedlichen Kontaktierung,
Fig. 4 und Fig. 5 unterschiedliche Ansichten eines Kontaktstiftes
Fig. 6 eine schematische Darstellung eines Teilbereiches einer Stromschienenanordnung,
Fig. 7 eine Ausgestaltung eines Installationsgerätes, von unten,
Fig. 8 eine Seitenansicht des Gerätes gemäß Fig. 12,
Fig. 9 eine Schmalseitenansicht des Gerätes gemäß den Figuren 12 und 13 und
Fig. 10 eine Geräteverriegelung, mit der ein Gerät auf einem Stromschienengehäuse fixiert werden kann.

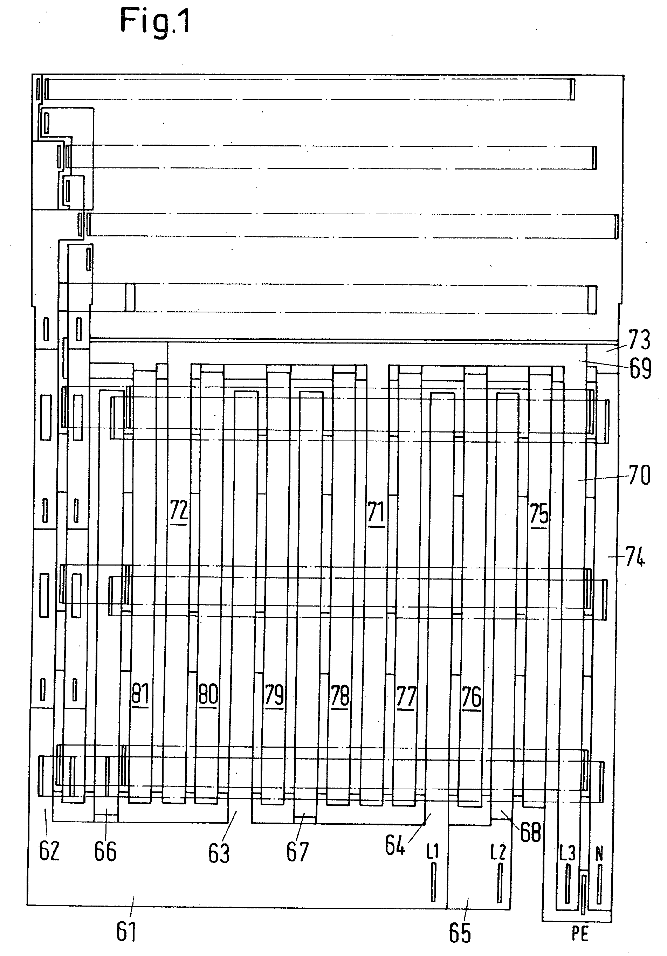

Es sei Bezug genommen auf die Fig. 1.

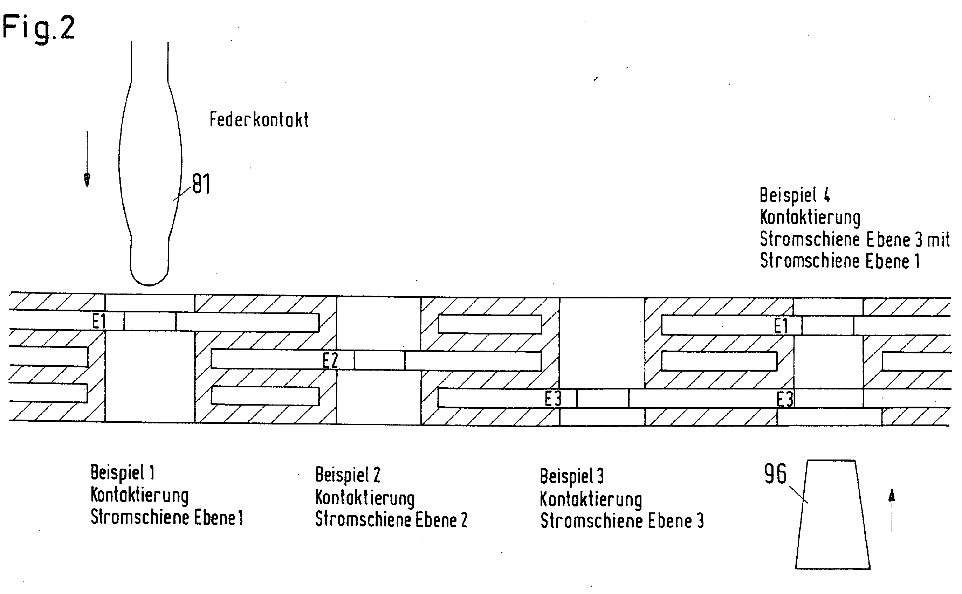

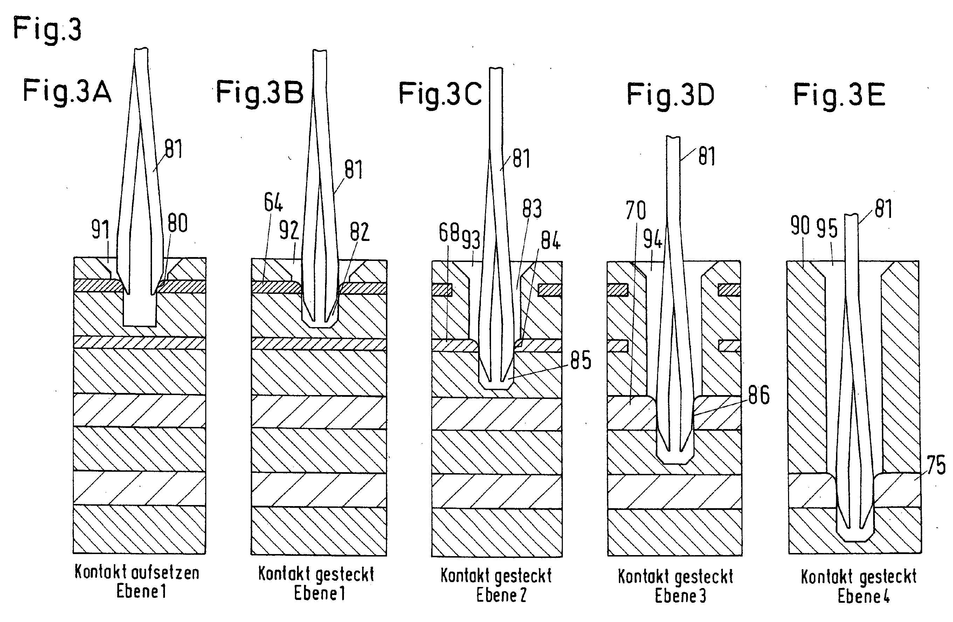

Fig. 1 zeigt eine Aufsicht auf eine Stromschienenanordnung, die in ein Stromschienengehäuse eingesetzt werden kann, wie es in den Fig. 2 und 3 dargestellt ist.

Die Stromschiene L1 besitzt ein senkrecht zur Anreihrichtung der Installationsgeräte verlaufendes Verbindungsstück 61, an dem senkrecht dazu Zungen 62, 63 und 64 angeformt sind. Die Länge des Verbindungsstückes 61 entspricht dem Abstand der Installationsgerätereihen voneinander und die Länge der Zungen 62 bis 64 entspricht der Länge der angereihten Installationsschaltgeräte in Anreihrichtung gesehen.

In ähnlicher Weise ist die Stromschiene L2 aufgebaut. Sie besitzt einen Verbindungssteg 65, an dem eine der Anzahl der Phasen entsprechende Anzahl von Zungen 66,67 und 68 angeformt ist. Die Zungen 66 und 62 67 und 63,68 und 64 verlaufen parallel zueinander und springen von ihren Verbindungsstegen in die gleiche Richtung vor.

Diesen beiden Phasenleitern ist ein dritter Phasenleiter L3 zugeordnet zu, der ein Verbindungsteil 69 besitzt, an dem Zungen 70,71 und 72 angeformt sind. Das Verbindungsteil 69 befindet sich die in der Nähe der Enden der Zungen 62,66 ; 63,67 ; 64,68 und die Zungen 70,71 und 72 springen in entgegengesetzte Richtung zu den Verbindungsstücken 61 und 65 vor.

Zugeordnet zu den drei Phasenleitern ist ein Neutralleiter N, der einen ähnlichen Aufbau besitzt, mit einem Verbindungsstück 73 unterhalb des Verbindungsstück des 69 und mit den die gleiche Richtung wie die Zungen 70,71 und 72 vorspringenden Zungen 74,75,76,77,78,79,80,81. Weiterhin ist als PE - Leiter eine Platte vorgesehen, die unterhalb der einzelnen Phasenschienen und des Neutralleiters liegt.

Die Fig. 3 zeigt einen Querschnitt durch die in Isolierstoffmaterial eingebetteten Stromschienen. Man erkennt, dass die einzelnen Stromschienen in unterschiedlichen Ebenen angeordnet sind. Beispielsweise die Stromschiene L1 befindet sich mit ihrer Zunge 64 in der ersten Ebene, d. h. in der obersten Ebene. Man erkennt, dass diese Sammelschiene bzw. Zunge 64 Öffnungen 80 aufweist, durch die weiter unten näher dargestellte Kontaktfedern 81 hindurch greifen. In der Zeichnung ganz links Fig. 3 a schnäbelt die Kontaktfeder 81 die Öffnung 80 gerade an ; die der Fig. 3b greift die Kontaktfeder 81 in ein unterhalb der Zunge 64 befindliches Sackloch 82 ein.

In der Ebene unterhalb der Zunge 64 befindet sich die Zunge 68 ; durch eine Durchgangsöffnung 83 hindurch kommt ein Kontaktfederelement 81 mit der Zunge 68 in Berührung, wobei die Zunge 68 durch eine Öffnung 84 in der Zunge 68 die in ein darunter befindliches Sackloch 85 eingreift. Eine Kontaktierung der Zunge 64 wird dadurch vermieden, daß die Durchgangsöffnung 83 ausreichend groß bemessen wird.

In der weiter darunter liegenden Ebene könnte beispielsweise eine Zunge 70 vorgesehen sein, durch deren Öffnung 86 hindurch die Kontaktfeder 81 hindurch gesteckt wird ; bei der Fig. 3e ist die Kontaktfeder 81 mit einer Sammelschiene in der 4. Ebene, d. h. mit der Zunge beispielsweise des Neutralleiters 75 kontaktiert .

Die Fig. 3 (3a bis 3e) zeigt, dass die einzelnen Sammelschienen in den Isolierstoffkörper 90 eingebettet sind, der Zugang zu Öffnungen 90,92,93/84,94 und 95 zu den einzelnen Zungen aufweist.

Die Zeichnung Fig. 2 zeigt die Anordnung gemäß Fig. 3 in schematischer Darstellung, wobei keine vier Ebenen, sondern lediglich drei Ebenen von Sammelschienen übereinander liegend dargestellt sind.

Die Kontaktfeder der Fig. 2 besitzt die gleiche Bezugsziffer 81, obwohl der Aufbau geringfügig anders ist, um die Ähnlichkeit bezüglich der Funktion darzustellen.

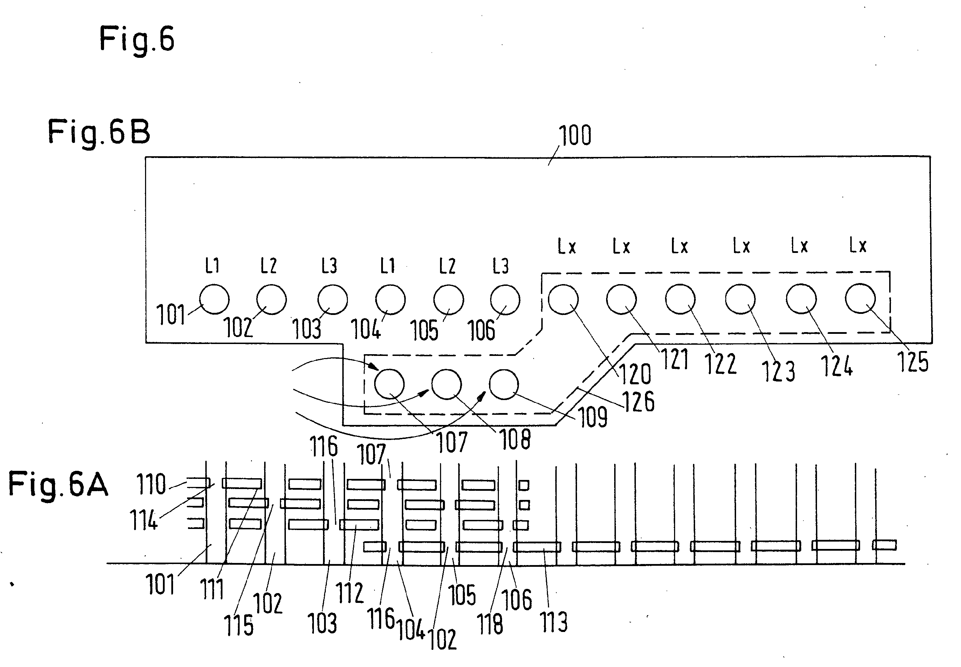

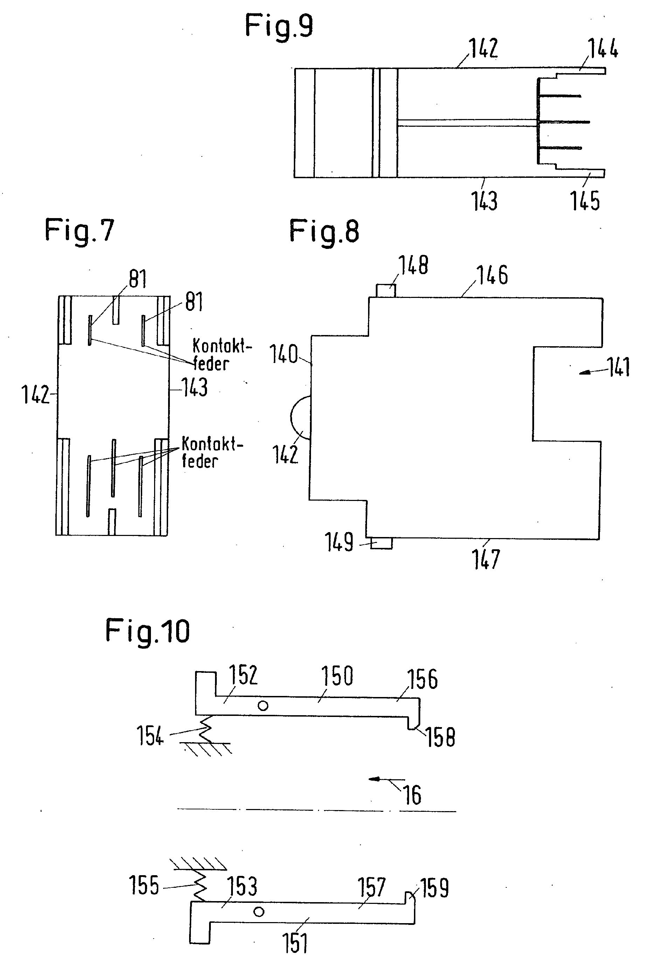

Die Fig. 2 zeigt weiterhin ein Kontaktelement 96, welches in der Ebene 1 und in der Ebene 3 befindliche Sammelschienen miteinander verbindet. Der Grund, warum dieses erforderlich ist, ist aus der Fig. 6 ersichtlich. Das die Sammelschienen aufnehmende Isolierstoffgehäuse 100, welches dem Isolierstoffgehäuse 90 der Fig. 8 entspricht, besitzt Öffnungen 101, 102, 103, 104, 105 und 106 sowie Öffnungen 107, 108 und 109.

Die Fig. 6 zeigt einen der Fig. 3 entsprechenden Schnitt durch ein Sammelschienengehäuse ; hierbei sind insgesamt vier Sammelschienenebenen 110, 111, 112 und 113 vorgesehen. Die im Bereich der Öffnung 101 befindliche Sammelschiene 110 besitzt einen Durchbruch 114, der kleiner ist als der Durchmesser des Loches 101. In dem Durchbruch 102 besitzt die Sammelschiene 111 einen Durchbruch 115, der gleich groß ist als der Durchbruch 114, somit kleiner als das Loch 102 ist. Im Bereich des Loches 103 besitzt die Sammelschiene 112 einen Durchbruch 116, dessen Innendurchmesser dem Innendurchmesser 114 und 115 entspricht. Wenn nun ein Modul mit Kontaktfedern, beispielsweise Kontaktfingern gemäß Fig. 3, in die Öffnungen 101, 102, 103 eingefügt werden, dann kontaktieren diese Kontaktfedern einerseits die Sammelschiene 110, darüber hinaus die Sammelschiene 111 und die Sammelschiene 112.

Unterhalb dieser drei Sammelschienen 110, 111 und 112 befindet sich die Sammelschiene 114 ; man erkennt, dass diese Sammelschiene 113 Öffnungen 116,1 117 und 118 besitzt; diese Öffnungen 116 bis 118 besitzen den gleichen Durchmesser wie die Öffnung 114, 115 und 116 und liegen übereinander, sodass die Phase der Sammelschiene 110 mittels eines Kontaktstückes, beispielsweise des Kontaktstückes 96, auf die Sammelschiene 113 gelegt werden kann. Zu diesem Zweck wird in die Öffnung 107 das Kontaktstück eingefügt, welches die Sammelschienen 110 und 113 miteinander verbindet.

In gleicher Weise könnte die Sammelschiene 111 mit der Sammelschiene 113 bzw. die Sammelschiene 112 mit der Sammelschiene 113 kontaktiert werden.

In der Fig. 6 a sind rechts von Löchern 101 bis 106 in einer Linie damit liegend weitere Löcher 120, 121, 122 123, 124 und 125 vorgesehen ; über die Sammelschiene 113 können dann in die Löcher 120 bis 125 eingesteckte Installationsgeräte je nach Bedarf auf die Phase gelegt werden, die in der Sammelschiene 110, in der Sammelschiene 111 oder in der Sammelschiene 112 gegeben ist. Die Fig. 11 zeigt eine entsprechende Verbindungsleitung 126 in strichlierter Darstellung.

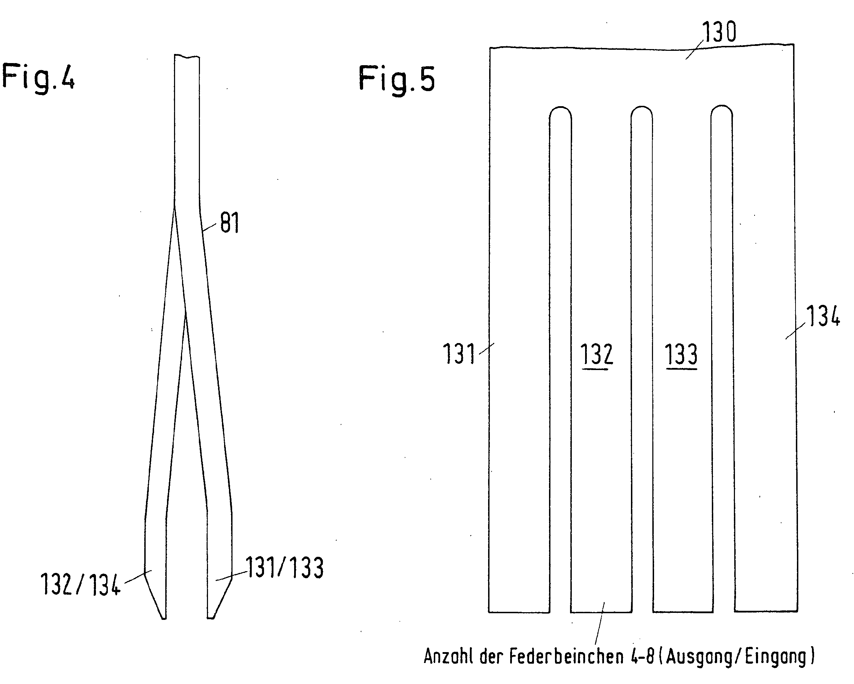

Die Fig. 4 und 5 zeigen eine Kontaktfeder 81. An einem gemeinsamen Kontaktträger 130 sind zinken - förmig Zungen 131,1 132,1 133 und 134 angeformt, die gegeneinander verbogen sind, wie aus der Fig. 9 ersichtlich. Dort sind nach rechts (siehe Fig. 4) ausgebogen die Zungen 131 und 133 und nach links ausgebogen die Zungen 132 und 134.

Die Figuren 7 bis 10 zeigen eine Ausgestaltung eines Installationsgerätes. Das Gerät ist etwa T - oder sockelförmig mit einer Frontseite 140 und einer Befestigungsseite 141 ausgebildet. An der Frontseite befindet sich eine Fläche mit Bedienelementen 142. Auf der Befestigungsseite ragen Kontaktfedern 81 in einer entsprechenden Zuordnung zueinander. An den Breitseiten 142 und 143 schließen Stege 144 und 145 an, die in der Ebene der Breitseiten liegen und zur Führung des Gerätes im Gehäuse der Sammelschienen dienen.

An denen Schmalseiten 146 und 147 sind vorspringende Nasen 148,1 149 angeformt, über die das Gerät mittels der Geräteverriegelung gemäß Fig. 10 fixiert werden kann. Die Anordnung gemäß Fig. 10 besitzt zwei drehbar gelagerte Doppelarmhebel 150 und 151, wobei an den Hebelarmen 152 und 153, die der Befestigungsseite zugewandt sind, Federn 154 und 155 angreifen, die die Arme 152, 153 auseinander - und die anderen Arme 156 und 157 gegeneinander drücken. Die freien Enden der Arme 156 und 157 besitzen aufeinanderzuweisende Nasen 158 und 159 ; bei der Montage greifen die Nasen 158 und 159 hinter die Leisten 148 und 149, wobei das Modul mit der Bodenseite 141 in Pfeilrichtung 160 zwischen die beiden Doppelarmhebel 51 und 151 eingefügt wird.

## Patentansprüche

1. In einem Gehäuse untergebrachte elektrische Installationsverteilung, mit einem in das Gehäuse eingeführtem Zugangsleiter und zu einzelnen Verbrauchern führenden Abgangsleitern, mit elektrischen Installationsgeräten, wie z. B. Fehlerstromschutzgeräten, Leitungsschutzgeräten und dergleichen, die mit mit dem Zugangsleiter und den Abgangsleitern verbundenen Stromschienen mittels einer Steckverbindung verbindbar sind, und mit einer Tragplatte zur Halterung der Installationsgeräte, wobei die Stromschienen unterhalb der Tragplatte angeordnet sind und die Tragplatte Öffnungen aufweist, in die an den Installationsgeräten angeordnete Steckelemente zu den Stromschienen hin einführbar sind, **dadurch gekennzeichnet, daß** die Stromschienen unterschiedlicher Phase und Zu- und Abgängen in gleichen Ebenen gegeneinander und voneinander isoliert angeordnet und in ein Isoliergehäuse eingebettet, vorzugsweise eingegossen, sind.

2. Installationsverteilung nach Anspruch 1, **dadurch gekennzeichnet, daß** jede Sammelschiene für jede Phase je einen quer zur Anreihrichtung der Geräte verlaufenden Verbindungsabschnitt aufweist, an dem eine der Anzahl der Installationsreihen entsprechend der Anzahl von Zungen angebracht sind, die unterhalb der Geräte verlaufen und die die Aufnahmeöffnungen für die Steckelemente aufweisen.

3. Installationsverteilung nach einem der vorigen Ansprüche, **dadurch gekennzeichnet, daß** die Sammelschiene für den Neutralleiter einen quer zur Anreihrichtung der Installationsgeräte verlaufenden Verbindungsabschnitt aufweist, an dem eine der Anzahl der Installationsreihen entsprechend der Anzahl von Zungen angebracht sind, die unterhalb der Installationsgeräte verlaufen und die die Aufnahmeöffnung für die Steckelemente aufweisen.

4. Installationsverteilung nach einem der vorigen Ansprüche, **dadurch gekennzeichnet, daß** die Sammelschienen übereinander angeordnet und die Zungen unterschiedlicher Phasen gegeneinander versetzt sind.

5. Installationsverteilung nach einem der vorigen Ansprüche, **dadurch gekennzeichnet, daß** die Zungen der Stromschienen in gleicher Ebene und die Zungen wenigstens zweier Stromschienen in einer weiteren Ebene liegen.

6. Installationsverteilung nach einem der vorigen Ansprüche, **dadurch gekennzeichnet, daß** bevorzugt die Zungen einer Phase in einer Ebene und die der anderen Phasen und des Neutralleiters in einer anderen Ebene liegen.

7. Installationsverteilung nach einem der vorigen Ansprüche, **dadurch gekennzeichnet, daß** insbesondere für einphasige Geräte zwei in unterschiedlichen Ebenen angeordnete Sammelschienen mittels eines Verbindungselementes auf eine Phase legbar sind.

8. Installationsverteilung nach einem der vorigen Ansprüche, **dadurch gekennzeichnet, daß** die Steckelemente wenigstens ein Zungenpaar aufweisen, die federnd quer zur Steckrichtung ausgebildet sind.

9. Installationsverteilung nach einem der vorigen Ansprüche, **dadurch gekennzeichnet, daß** die Steckelemente zwei quer zur Steckrichtung versetzte und federnde Zungen aufweisen.
